# EUROPEAN PATENT APPLICATION

(11) **EP 1 381 260 A1**
(43) Date of publication of application: **14.01.2004**
(21) Application number: 02254876.2
(22) Date of filing: 11.07.2002
(51) Int. Cl.: H05K 3/24, H05K 3/28

(54) **Method of plating connecting layers on a conductor pattern of a printed circuit board (PCB)**

(71) Applicant: Ultratera Corporation, Hsin-Chu (TW)
(72) Inventor: Maa, Chong-Ren, Taipei (TW); Chih, Wan-Kuo, Hsinchu (TW); Tsou, Ching-Hua, Yunghe City, Taipei (TW)
(74) Representative: O'Connell, David Christopher

(57) **Abstract**

A method of plating connecting layers (the Ni-Au layers) on a conductor pattern of a printed circuit board (PCB) comprises the steps of: A. Prepare a substrate (10) with a conductor pattern (20) thereon. B. Coat a masking layer (30) onto the substrate (10), wherein the conductor pattern (20) is sheltered by the masking layer (30) but exposed at plating portions (24) and conductive portions (22) thereof. C. Plate a conductive layer (50) onto the masking layer (30), wherein the conductive layer (50) is electrically connected with the conductor pattern (20) at the conductive portions (22). D. Coat a second masking layer (60) onto the conductive layer (50), wherein the plating portions (24) of the conductor pattern (20) are exposed. E. Adding voltage to the conductive layer (50) to plate connecting layers (70) onto the plating portions (24) of the conductor pattern (20) respectively. F. Remove the second masking layer (60), and G. Remove the conductive layer (50).

## Description

### FIELD OF THE INVENTION

The present invention relates to an electronic industry, and more particularly to a method of plating connecting layers on a conductor pattern of a PCB.

### BACKGROUND OF THE INVENTION

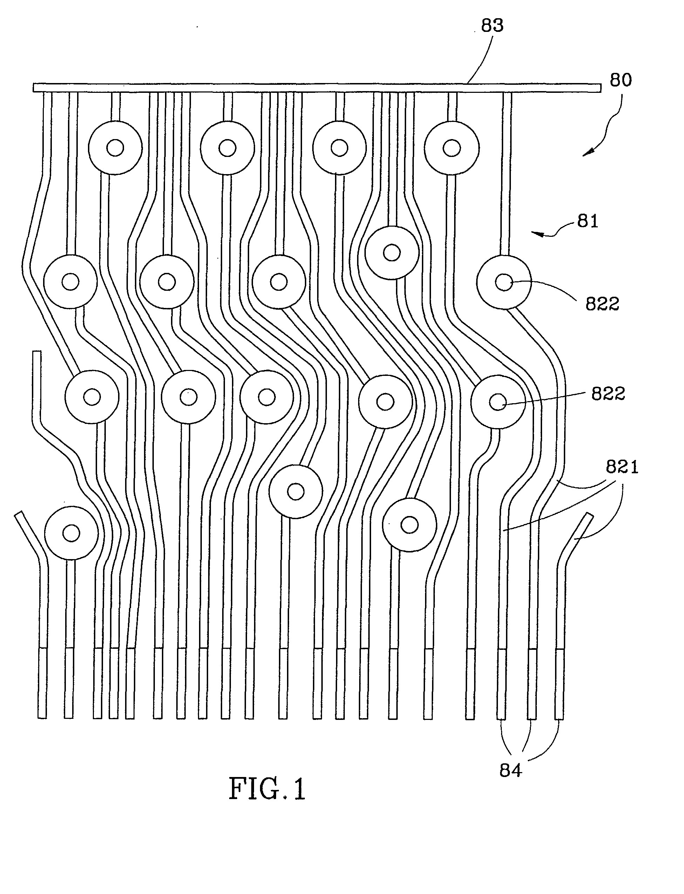

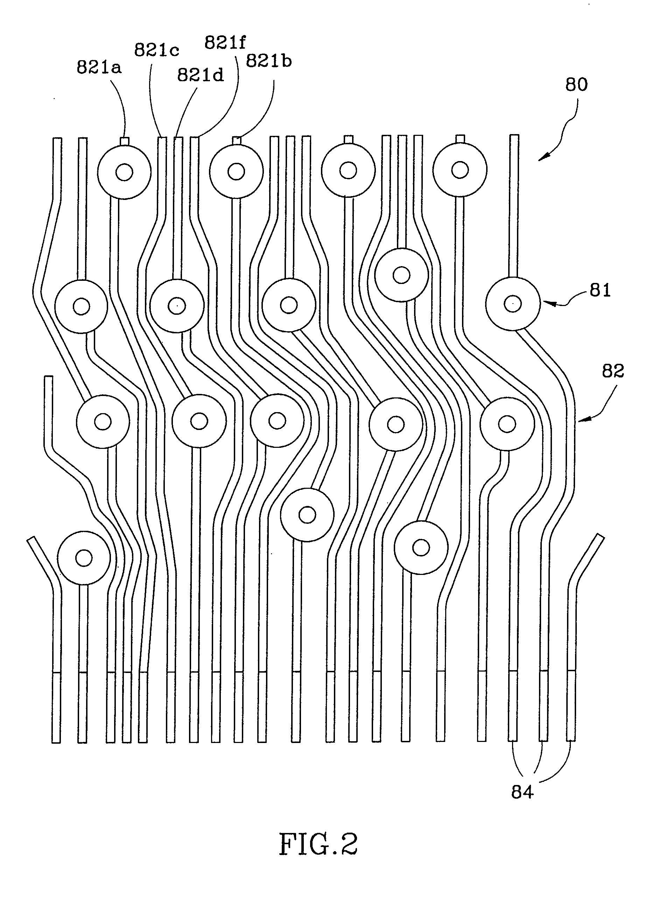

In a conventional method of manufacturing a printed circuit board (PCB) 80, please refer to FIG. 1, first, prepare a substrate 81 with a conductor pattern 82 thereon. The conductor pattern 82 is composed of a plurality of traces 821 in specific layout. Plated through holes (PTHS) 822 are provided to the substrate 81. A bus trace 83 is provided on the substrate 81 electrically connected with the tail ends of the traces 821. Electricity is added to the bus trace 83 to plate connecting layers 84 (the Ni-Au alloy layers) on the conductor pattern 82. After the plating process, the bus trace 83 is removed to form the conductor pattern 82 of the PCB 80 as shown in FIG. 2.

It is obvious to understand that spaces 811 must be left on the substrate 81 between the traces 821a and 821b for invalid sections 821c, 821d and 821 f, which are the sections of the traces 821 having no current flowing, passing though. In the other words, the substrate 81 has a larger invalid space thereon where has no flowing in the conductor pattern 82 and can not be eliminated.

### SUMMARY OF THE INVENTION

The primary objective of the present invention is to provide a method of plating connecting layers on a conductor pattern of a printed circuit board, which provides no bus trace on the substrate in the procedures.

According to the objective of the present invention, a method of plating connecting layers on a conductor pattern of a printed circuit board comprises the steps of:
A. Prepare a substrate with a conductor pattern thereon, wherein the conductor pattern has plating portions and conductive portions.
B. Apply a masking layer onto the substrate, wherein the conductor pattern is sheltered by the masking layer but exposed at the plating portions and the conductive portions thereof.
C. Apply a conductive layer onto the masking layer, wherein the conductive is electrically connected with the conductor pattern at the conductive portions.
D. Apply a second masking layer onto the conductive layer and expose the plating portions of the conductor pattern.
E. Adding electricity to the conductive layer to plate connecting layers onto the plating portions of the conductor pattern respectively.
F. Remove the second masking layer, and
G. Remove the conductive layer.

### BRIEF DESCRIPTION OF THE DRAWINGS

FIG. 1 is a perspective view of a conventional PCB, showing a bus trace provided on the substrate to plate connecting layers on the conductor pattern;
FIG. 2 is a perspective view of the conventional PCB, showing the bus trace and invalid trace being removed;
FIG. 3 is a schematic view of a prefer embodiment of the present invention;
FIG. 4 is a perspective view of the conductor pattern of the PCB of the prefer embodiment of the present invention
FIG. 5 is a perspective view of another conductor pattern of the PCB of the prefer embodiment of the present invention, and
FIG. 6 is a perspective view of the third conductor pattern of the PCB of the prefer embodiment of the present invention.

### DETAIL DESCRIPTION OF THE INVENTION

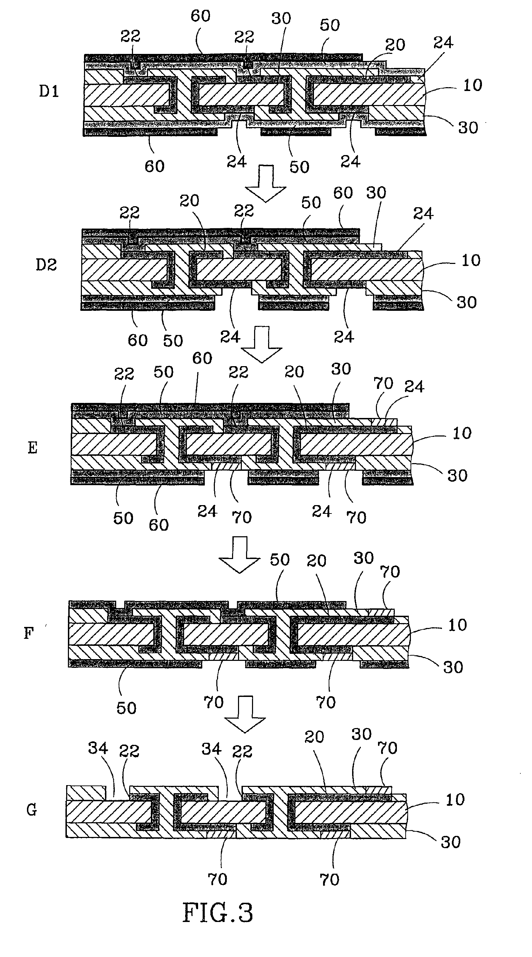

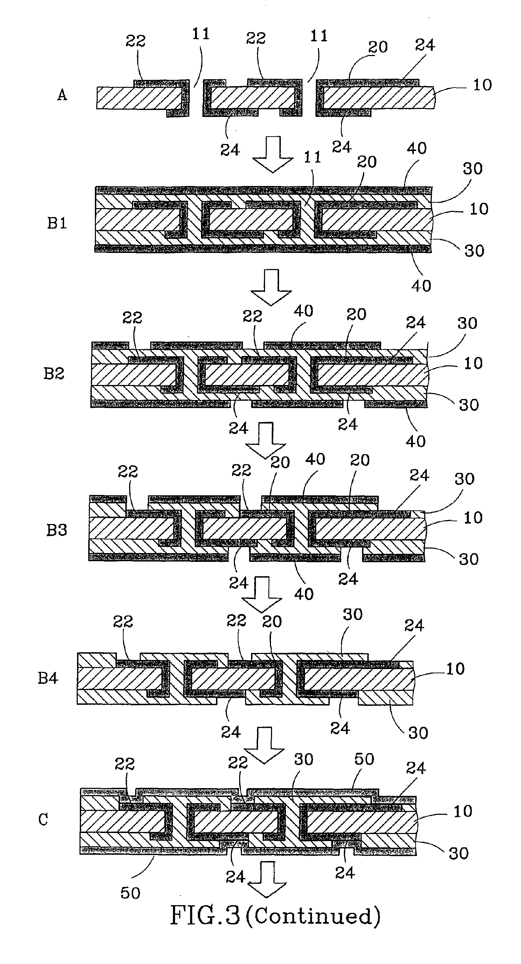

Please refer to FIG. 3, a method of plating connecting layers on a conductor pattern of a printed circuit board (PCB) of a prefer embodiment of the present invention comprises the steps of:
A. Prepare a substrate 10 with a conductor pattern 20 thereon:
   Please refer to FIG. 3 A, the substrate 10 is made of multi-function epoxy resin, where drills a plurality of plated through holes (PTHS) 11 at specific positions thereof and prints a conductor pattern 20 onto the both sides thereof.
   The conductor pattern 20 defined two sets of portions, namely, plating portions 22 where are to plate connecting layers thereon later and conductive portions 24 where are electrically connected with the plating portions 22.
   The processes to manufacture the substrate 10 and the conductor pattern can be found in many related inventions, so I will not describe the detail there.
B. Coat a masking layer 30 on the substrate 10 sheltering the conductor pattern 20 but expose the plating portions 22 and the conductive portions 24:
   Please refer to FIG. 3 from B1 to B4, in the step B, we provide four sub-procedures, which are
B1. Attach two resin coated metal laminations 40 onto both sides of the substrate 10 respectively:
   The resin coated metal lamination has a metal foil 40 and mask resin material 30 on a side of the metal foil 40. The resin coated metal lamination of the prefer embodiment of the present invention can be a resin coated copper (RCC) lamination, wherein the metal foil 40 is a copper foil and the mask resin material 30 is multi-function epoxy resin which is the material as same as the substrate 10.
   The RCC laminations are attached onto the substrate 10 with a predetermined pressure, baking temperature and baking time applied onto them, such that the epoxy resin will fill the PTHS 11. After the epoxy resin has solidified, it will form the masking layer 30.
B2. Remove of unnecessary metal foil 40:
   Photo image treatment is applied in this sub-procedure. First, coat a photo-resist film (not shown) onto the copper foil 40, and subject the photo-resist film to UV light exposure in conjunction with a negative film so that the photo resist generates images at specific positions. Develop the photo-resist film using sodium carbonate (Na₂CO₃) solution with specific gravity 1 wt% and temperature 20°C~30°C and etch the copper foil 40 using ferric chloride (FeCl₃) solution with concentration 40~45 Be' and temperature 40°C~50°C or using cupric chloride (CuCl₂) with concentration 35~45 Be' and temperature 40°C~50°C, so that the masking layer 30 is exposed at where the copper foil 40 was removed, and then remove the residual photo resist. The PCB of the present invention now will be as FIG. 3 B2 shown.
   The removed portions of the metal foil 40 relate to the plating portions 22 and the conductive portions 24 of the conductor pattern 20 respectively.
B3. Remove the exposed portions of the masking layer 30 to expose the plating portions 22 and the conductive portions 24 of the conductor pattern 20:
   Plasma etching is applied to remove the exposed portions of the masking layer 30, so that the conductor pattern 20 is exposed at the plating portions 22 and the conductive portions 24 (as shown in FIG. 3 B3).
B4. Remove the residual copper foil 40:
   Chemical solutions etching treatment is applied to remove the residual copper foil 40 to form the PCB as shown in FIG. 3 B4.
C. Plate a conductive layer 50 onto the masking layer 30 electrically connected with the conductor pattern 20 at the plating portions 22 and the conductive portions 24:
   Chemical Plate electroless copper onto the masking layer 30 first with a thickness of about 0.05um~0.5um. And then, electrolytic copper plating is applied onto it using copper sulfate (CuSO₄) solution with current density of 10~100 Amp/dm² and plating time of 1~10 min. The thickness of the electrolytic copper layer is about 1~3 um. The electroless and electrolytic copper layer forms aforesaid conductive layer 50 as shown in FIG. 3 C.
   We found that the strong alkali electroless Cu solution will attack conventional solder mask. But the anti-alkali property of resin mask is quit well. That is why we choose the multi-function epoxy resin to be the material of the masking layer 30.
D. Coat a second masking layer 60 onto the conductive layer 50 and expose the conductive layer 50 at portions of relating to the plating portions 22 of the conductor pattern 20:
   Step D is similar to step B comprising two sub-procedures:
D1. Coat a photo-resist film onto the conductive layer 50, then expose and develop the photo-resist film to make the conductive layer 50 exposed at where the portions relate to the plating portions 22 of the conductor pattern 20. The photo-resist film is aforesaid second masking layer 60 in this step.
D2. Quick etching treatment is applied to remove the exposed portions of the conductive layer 50 to make the plating portions 22 of the conductor pattern 20 exposed. The quick etching solution is sulfuric acid and hydrogen peroxide solution.
   After step D, the conductive layer 50 is electrically connected with the conductor pattern 20 via the conductive portions 24 and the plating portions 22 of the conductor pattern 20 are exposed.
E. Add electricity to the conductive layer 20 to conduct to the conductor pattern 20 for plating connecting layers 70 onto the plating portions 22 of the conductor pattern 20. The connecting layers 70 are Ni-Au alloy layers in the prefer embodiment of the present invention.
   The openings of the second masking layer 60 are larger than the corresponding plating portions 22 of the conductor pattern 20 to make the plating portions 22 having full areas plating the connecting layers 70 thereon.
F. Etching treatment is applied to remove the residual second masking layer 60 (the photo-resist film). The etching solution is sodium hydroxide (NaOH) solution with specific gravity 2~5 wt% and temperature 50°C~80°C or potassium hydroxide (KOH) solution with same specific gravity and temperature, and
G. Alkali etching treatment is applied to remove the conductive layer 50 and the conductive portions 24 of the conductor pattern 20 are removed in the same time.

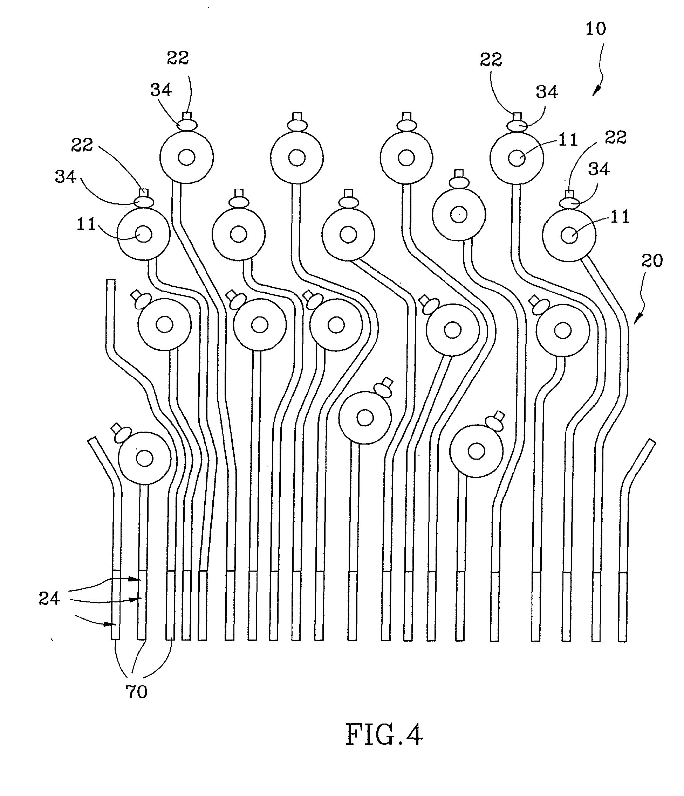

After step G, there are holes 34 left at the masking layer 30 related to the conductive portions 24 of the conductor pattern 20. Please refer to FIG. 4, the holes 34 are located at the positions of where has no current flowing through the conductor pattern 20, such as located behind the PTHS 11 or behind the pad land.

In conclusion, the present invention provide a method to plate connecting layers on the conductor pattern of a PCB without having to provide a bus trace as the conventional process did. In the other words, there will be no invalid section of the conductor pattern on the substrate, so that, you can compare FIG. 2 with FIG. 4, the substrate and the conductor pattern can be reduced the sizes thereof.

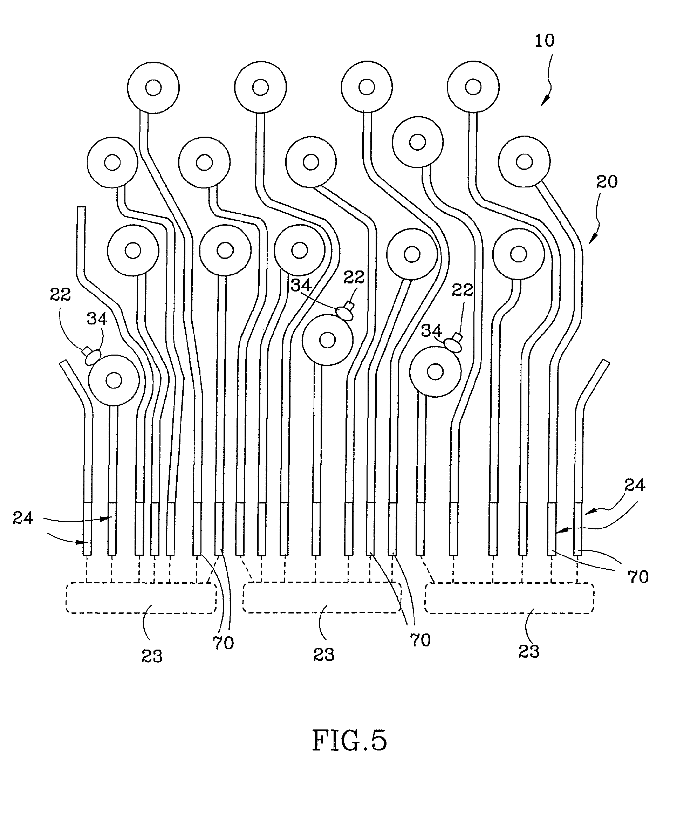

Please refer to FIG. 5, the conductor pattern 20 also can be provided with conducting portion 23 (as the dot line shown in FIG.) to electrically connected with the traces where needs to plate the connecting layers 70 thereon, such that there is no need to conduct the conductive layer 50 with each trace where needs to plate the connecting layers 70 on the conductive portions 22. Thus, there is only one or two holes 34 are left on the masking layer 30 at each set of the traces connected by the conducting portion 23.

The main procedures to manufacture the PCB shown in FIG. 5 are similar to the aforesaid embodiment, the additional procedure are:
1) The conductor pattern 20 is provided with the conducting portion 23 at initial in Step A.
2) The masking layer 30 is removed at where relates to the conducting portion 23 too in Step B.
3) In Step D, the photo-resist is removed at where relates to the plating portions 22 and the conducting portion 23 and then remove the exposed portions of conductive layer 50. A second photo-resist is coated to be opened at where relates to the plating portions 22 to form the second masking layer 60. Whether the original photo-resist is removed before coating the second photo-resist that is a selection of manufacture.
4) The conducting portions 23 of the conductor pattern 20 are removed in step G.

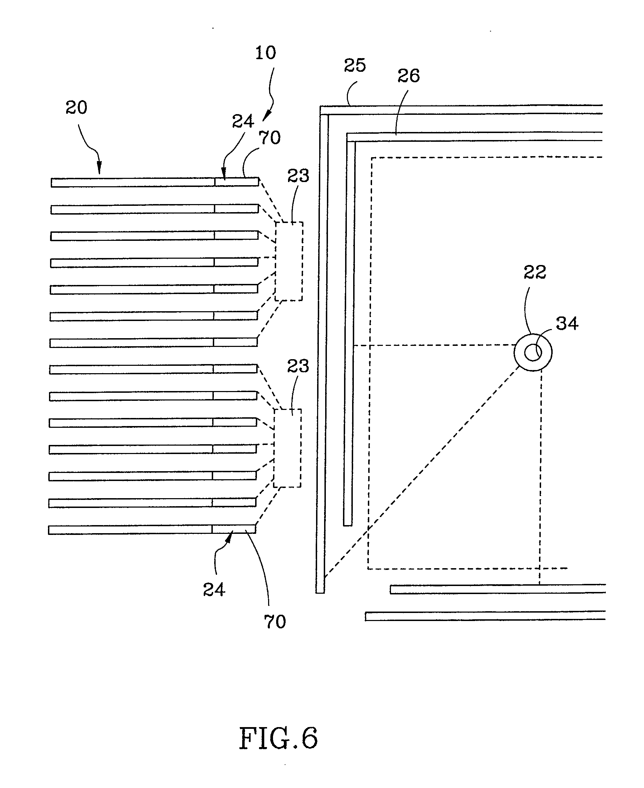

FIG. 6 shows another perspective of the PCB of the present invention, wherein the substrate 10 will be cut off along the dot line shown in FIG. to form a cavity. A conductive portion is provided on the substrate 10 to circuit the power line 25, the ground line 26, the conducting portions 23, the plating portions 22 and the conductive layer 50. The conductive portion 23 is located at where the substrate 10 will be cut off along the dot line 15 shown in FIG. to form a cavity.

## Claims

1. A method of plating connecting layers on a conductor pattern of a printed circuit board, comprising the steps of:
A. preparing a substrate with a conductor pattern thereon, wherein said conductor pattern comprises plating portions and conductive portions and said conductive portion is conducted with at least one of said plating portion via said conductor pattern;
B. applying a masking layer onto said substrate, wherein said masking layer shelters said conductor pattern but exposes said plating portions and said conductive portions;
C. applying a conductive layer onto said masking layer, wherein said conductive is electrically connected with said conductor pattern at said conductive portions;
D. applying a second masking layer onto said conductive layer and exposing said plating portions of said conductor pattern;
E. adding electricity to said conductive layer to plate connecting layers onto said plating portions of said conductor pattern respectively;
F. removing said second masking layer, and
G. removing said conductive layer.

2. The method of plating connecting layer on a conductor pattern of a printed circuit board as define in claim 1, wherein the step B has sub-steps of:
B1. attaching a metal foil with mask resin material thereon onto said substrate and baking said mask resin material to make it solidifying to form said masking layer;
B2. applying chemical solution etching to remove unnecessary portions of said metal foil at where the portions relate to said conductive portions and said plating portions of said conductor pattern to expose said masking layer at these portions;
B3. applying plasma etching to remove the exposed portions of said masking layer to expose said conductive portions and said plating portions of said conductor pattern;
B4. removing said metal foil.

3. The method of plating connecting layer on a conductor pattern of a printed circuit board as define in claim 1, wherein the step D has sub-steps of:
D1. applying a photo-resist layer onto said conductive layer, then expose and develop it to expose said conductive layer at portions of relating to said plating portions of said conductor pattern, wherein said photo-resist layer is said second masking layer, and
D2. applying chemical solution etching to remove the exposed portions of said conductive layer to expose said plating portions of said conductor pattern.

4. The method of plating connecting layer on a conductor pattern of a printed circuit board as define in claim 1, wherein said conductive portions of said conductor pattern are removed in step G.

5. The method of plating connecting layer on a conductor pattern of a printed circuit board as define in claim 1, wherein an electroless metal layer is provided on said masking layer to form said conductive layer in step C.

6. The method of plating connecting layer on a conductor pattern of a printed circuit board as define in claim 5, wherein an electrolytic metal layer is provided on the electroless metal layer.

7. The method of plating connecting layer on a conductor pattern of a printed circuit board as define in claim 1, wherein said masking layer has holes left at portions of relative to said conductive portions of conductor pattern after step G.

8. The method of plating connecting layer on a conductor pattern of a printed circuit board as define in claim 2, which further comprises a sub-step before step B2: applying a photo-resist film onto said metal foil, and then exposing and developing said photo-resist film to expose said metal foil at portions thereof related to said conductive portions and plating portions of said conductor pattern.

9. The method of plating connecting layer on a conductor pattern of a printed circuit board as define in claim 8, wherein the solution to develop said photo-resist film is sodium carbonate (Na₂CO₃) solution with specific gravity 1 wt% and temperature 20°C~30°C.

10. The method of plating connecting layer on a conductor pattern of a printed circuit board as define in claim 2, wherein the etching solution to remove said metal copper foil in step B2 is ferric chloride (FeCl₃) solution with concentration 40~45 Be' and temperature 40°C~50°C.

11. The method of plating connecting layer on a conductor pattern of a printed circuit board as define in claim 2, wherein the etching solution to remove said metal copper foil in step B2 is cupric chloride (CuCl₂) with concentration 35~45 Be' and temperature 40°C~50°C.

12. The method of plating connecting layer on a conductor pattern of a printed circuit board as define in claim 1, wherein alkali etching treatment is applied to remove said conductive layer in step G.

13. The method of plating connecting layer on a conductor pattern of a printed circuit board as define in claim 6, wherein the solution to plate electrolytic metal layer is copper sulfate (CuSO₄) solution with current density 10~100 Amp/dm² and plating time 1~10 min.

14. The method of plating connecting layer on a conductor pattern of a printed circuit board as define in claim 3, wherein the etching solution to remove said exposed conductive layer in step D1 is sulfuric acid and hydrogen peroxide solution.

15. The method of plating connecting layer on a conductor pattern of a printed circuit board as define in claim 1, wherein the etching solution to remove said second masking layer in step F is sodium hydroxide (NaOH) solution with specific gravity 2~5 wt% and temperature 50°C~80 °C or potassa (KOH) solution with same specific gravity and temperature.

16. The method of plating connecting layer on a conductor pattern of a printed circuit board as define in claim 1, wherein said conductor pattern further comprises at least a conducting portion, and said masking layer is removed at where relates to said conducting portion too in Step B, said conductive layer is removed at where relates to said conducting portion and said second masking layer shelters said conducting portion in Step D, and said conducting portion of said conductor pattern is removed in step G.

17. The method of plating connecting layer on a conductor pattern of a printed circuit board as define in claim 16, which further comprises procedures in Step D of applying a masking layer on said conductive layer and removing the unnecessary portions thereof to expose said conductive layer at where relates to said plating portions and said conducting portion; removing the exposed portions of said conductive layer, and then applying another masking layer sheltering said conducting portion and exposing said plating portions.
